(19) Europäisches Patentamt
European Patent Office
Office européen des brevets

(11) **EP 3 547 486 B1**

(12) **EUROPÄISCHE PATENTSCHRIFT**

(45) Veröffentlichungstag und Bekanntmachung des Hinweises auf die Patenterteilung:
**24.03.2021   Patentblatt 2021/12**

(51) Int Cl.:
*H02J 3/36* *(2006.01)*     *H01R 31/08* *(2006.01)*
*H02H 7/26* *(2006.01)*     *G01R 31/08* *(2020.01)*

(21) Anmeldenummer: **18163970.9**

(22) Anmeldetag: **26.03.2018**

(54) **VERFAHREN UND ANORDNUNG ZUR FEHLERDETEKTION IN EINER GLEICHSPANNUNGSLEITUNG**

METHOD AND ARRANGEMENT FOR DETECTING ERRORS IN A DC CONDUIT

PROCÉDÉ ET SYSTÈME DE DÉTECTION DE DÉFAILLANCE DANS UNE LIGNE DE TENSION CONTINUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**02.10.2019   Patentblatt 2019/40**

(73) Patentinhaber: **Siemens Energy Global GmbH & Co. KG**
**81739 München (DE)**

(72) Erfinder:
• **Al Hage Ali, Ali**
**91052 Erlangen (DE)**
• **Ebner, Günter**
**91239 Henfenfeld (DE)**

(56) Entgegenhaltungen:
**CN-B- 103 837 799**

• **LI CONGSHAN ET AL: "Fault-location method for HVDC transmission lines based on phase frequency characteristics", IET GENERATION, TRANSMISSION&DISTRIBUTION, IET, UK, Bd. 12, Nr. 4, 27. Februar 2018 (2018-02-27), Seiten 912-916, XP006065273, ISSN: 1751-8687, DOI: 10.1049/IET-GTD.2017.0967**
• **DAISY MOHAMMAD ET AL: "A new fault-location method for HVDC transmission-line based on DC components of voltage and current under line parameter uncertainty", ELECTRICAL ENGINEERING, SPRINGER, BERLIN, DE, Bd. 99, Nr. 2, 5. Juli 2016 (2016-07-05), Seiten 573-582, XP036237032, ISSN: 0948-7921, DOI: 10.1007/S00202-016-0384-3 [gefunden am 2016-07-05]**
• **PHILIPP TUNNERHOFF ET AL: "Comprehensive Fault Type Discrimination Concept for Bipolar Full-Bridge-Based MMC HVDC Systems with Dedicated Metallic Return", IEEE TRANSACTIONS ON POWER DELIVERY., Bd. 33, Nr. 1, 1. Februar 2018 (2018-02-01), Seiten 330-339, XP055508956, US ISSN: 0885-8977, DOI: 10.1109/TPWRD.2017.2716113**

**Beschreibung**

Die Erfindung betrifft ein Verfahren zum Detektieren eines Fehlers in einer Gleichspannungsleitung, die mit einer regelbaren Einrichtung zum Erzeugen eines Stromes in der Gleichspannungsleitung verbunden ist.

Die Neuorganisation der elektrischen Energieversorgung, die mit dem Wandel von fossiler zu regenerativer Energieerzeugung verbunden ist, stellt die Versorgungsinfrastruktur, insbesondere die Versorgungsnetze, vor große Herausforderungen. Ein besonderes Merkmal der stark zunehmenden Energieerzeugung aus Windkraft und Sonnenenergie ist deren räumliche Verteilung, die sich insbesondere nicht an den Verbraucherschwerpunkten orientiert. Daraus entsteht die Notwendigkeit, hohe Leistungen über weite Entfernungen zu übertragen. Die Technologie der Mittel- oder Hochspannungsgleichstromübertragung (MVDC, HVDC) stellt eine effektive Möglichkeit dar, hohe elektrische Leistungen über große Entfernungen mittels Freileitungen, Erd- oder Seekabel zu übertragen. MVDC- oder HVDC-Verbindungen können dabei in unterschiedlichen Ausführungsformen realisiert werden. Grundsätzlich kann in diesem Zusammenhang zwischen monopolaren und bipolaren Konfigurationen unterschieden werden. Diese Konfigurationen können mit einer Erdrückleitung oder einem metallischen Rückleiter (Dedicated Metallic Return, DMR) ausgeführt werden. Ausführungen mit geerdeten Elektroden sind meist als nachteilig angesehen, weil es zu Korrosion und anderen nachteiligen Erscheinungen auf dem Übergangsweg kommen kann. Aus diesem Grund werden bei vielen Anwendungen metallische Rückleiter bevorzugt.

Bezogen speziell auf eine bipolare Konfiguration verursacht ein Fehler keine kritischen Schäden an den Anlagenkomponenten, insbesondere, wenn sich das System in einem symmetrischen Betrieb befindet und der Fehler auf dem DMR ist. Die Verfügbarkeit ist jedoch eingeschränkt. Die bipolare Konfiguration bietet im Vergleich zur monopolaren eine erhöhte Verfügbarkeit, indem die gesamte zu übertragene Leistung auf zwei monopolare Systeme aufgeteilt wird. Bei Ausfall eines Pols sollte der verbleibende Pol in der Lage sein, den Betrieb monopolar, mittels der DMR-Leitung aufrechtzuerhalten. Bei einem Fehler in der DMR-Leitung kann dies jedoch nicht mehr gewährleistet werden.

Die Fehlererkennung in Gleichspannungsleitungen, insbesondere in metallischen Rückleitern, stellte bislang eine große Herausforderung dar. In dem Beitrag "Protection Strategy for HVDC Systems with Dedicated Metallic Return (DMR) Conductors" von V. Pathirana et al. wird ein Differenzialstromschutz vorgeschlagen, bei dem ein Gleichstrom in den DMR eingeprägt wird. Der Nachteil dieser Vorgehensweise besteht in der Notwendigkeit eines parallelen Telekommunikationssystems. Bei Ausfall einer solchen Kommunikation ist eine Fehlerdetektion auf der Basis des Differenzialstromschutzes nicht mehr möglich. Zudem benötigt der Differenzialstromschutz einen Reserveschutz, der idealerweise ohne Kommunikation funktionieren müsste.

Ein Verfahren zur Lokalisierung eines Fehlers in einer elektrischen Leitung ist aus dem Beitrag von Li et al. "Fault-location method for HVDC transmission lines based on phase frequency characteristics", IET, 2018. Das Verfahren basiert auf einer Phasen-Frequenz-Verschiebung.

Ein weiteres Verfahren zur Fehlerlokalisierung ist in dem Beitrag von Daisy et al. "A new fault-location method for HVDC transmission-line based on DC components of voltage and current under linke parameter uncertainty", Electr. Eng. 2017, offenbart. Dieses bekannte Verfahren basiert auf einer Bestimmung einer Spannung am Fehlerort.

Ein Verfahren, bei dem die Fehlerlokalisierung auf Impedanzmessung basiert, ist aus der CN103837799 B bekannt.

Die Aufgabe der Erfindung ist es, ein artgemäßes Verfahren vorzuschlagen, das die Nachteile des Standes der Technik überwindet und eine zuverlässige Fehlerdetektion in einer Gleichspannungsleitung erlaubt.

Die Aufgabe wird bei einem artgemäßen Verfahren dadurch gelöst, dass zumindest ein Sollwert einer Regelungseinrichtung zum Regeln der regelbaren Einrichtung für eine vorbestimmte Zeit derart eingestellt wird, dass ein zeitveränderlicher Strom durch die Gleichspannungsleitung erzeugt wird, eine Spannung und der Strom durch die Gleichspannungsleitung gemessen werden, eine Impedanz der Gleichspannungsleitung aus der gemessenen Spannung und dem gemessenen Strom bestimmt wird, aus der Impedanz ein Kennparameter abgeleitet wird, überprüft wird, ob der Kennparameter unterhalb einer vorbestimmten Parameterschwelle liegt, und, falls der Kennparameter unterhalb der Parameterschwelle liegt, eine Fehlermeldung erzeugt wird. Die regelbare Einrichtung kann beispielsweise ein Umrichter sein, der gleichspannungsseitig mit der Gleichspannungsleitung verbunden ist. Vorzugsweise ist der Umrichter ein selbstgeführter Umrichter, beispielsweise ein sogenannter modularer Mehrstufenumrichter. Mittels des Umrichters mit dessen Regelungseinrichtung kann eine Spannung und/oder ein Strom beziehungsweise eine Leistung in der Gleichspannungsleitung geregelt werden. Üblicherweise werden mittels des Umrichters eine Gleichspannung und/oder ein Gleichstrom eingestellt. Zur Fehlerdetektion wird die regelbare Einrichtung derart geregelt, dass zeitweise ein zeitveränderlicher Strom bzw. eine zeitveränderliche Spannung in der Gleichspannungsleitung erzeugt wird. Insbesondere kann es sich bei dem zeitveränderlichen Strom bzw. Spannung um einen Wechselstrom bzw. eine Wechselspannung handeln. Besonders wirksam kann ein solcher Wechselstrom in einer Gleichspannungsleitung erzeugt werden, in der in einem Normalbetrieb der regelbaren Einrichtung kein Strom oder ein vernachlässigbarer Strom fließt. Ein Beispiel einer solchen Gleichspannungsleitung ist die DMR-Leitung. Das erfindungsgemäße Verfahren bietet den Vorteil einer einfachen Fehlererkennung in der Gleichspannungsleitung. Es werden nur lokale Messgrößen verwendet, so dass eine Kommunikation mit entfernten Einheiten nicht notwendig ist. Das Verfahren kann bei beliebigen Topologien bzw. Konfigurationen angewandt werden, beispielsweise auch dann, wenn die Gleichspannungsleitung in einem Gleichspannungsnetz mit weiteren Gleichspannungsleitungen verbunden ist. Aufgrund der zuverlässigen Fehlererkennung in der Gleichspannungsleitung kann zudem die Verfügbarkeit der Leistungsübertragung erhöht werden. Der zumindest eine Sollwert kann beispielsweise ein Stromsollwert, ein Spannungssollwert, ein Leistungssollwert oder dergleichen sein.

Vorzugsweise ist der zeitveränderliche Strom ein periodischer Strom, insbesondere ein Sinusstrom. Bei periodischen Strömen, insbesondere bei einem Sinusstrom, können auf besonders einfache und effektive Weise Analysetechniken wie Fourier-Analyse angewandt werden. Dies kann beispielsweise dazu verwendet werden, die Impedanz und/oder den Kennparameter besonders genau zu ermitteln.

Bei manchen Anwendungen kann es von Vorteil sein, wenn der periodische Strom eine Frequenz von mindestens 50 Hz aufweist. Die Frequenz ist geeigneterweise so gewählt, dass die Induktivität der Leitung dominierend wird. Nichtlinearitäten in der Leitung sollten dabei möglichst nicht verstärkt werden. Der periodische Strom kann auch eine Überlagerung zwei oder mehrerer Sinusströme unterschiedlicher Frequenzen sein. Anhand jeder einzelnen Frequenz kann gesondert die Impedanz bestimmt werden, wodurch deren Bestimmung genauer werden kann.

Vorzugsweise wird die Impedanz unter Verwendung einer Fouriertransformation (Fast Fourier Transform, FFT) bestimmt.

Diese bekannte Methode erlaubt eine relativ genaue Bestimmung der Impedanz.

Gemäß der Erfindung ist der Kennparameter eine Entfernung. Es wird hierbei der Umstand genutzt, dass die spezifische Impedanz Zsp der Gleichspannungsleitung im fehlerfreien Fall bekannt ist. Das Verhältnis der gemessenen Impedanz Zm und der spezifischen Impedanz der Gleichspannungsleitung hat die Dimension einer Länge. Somit kann der Kennparameter D in diesem Fall folgendermaßen definiert werden:

$$D \ = \ Zm \ / \ Zsp.$$

Zudem kann der Kennparameter D direkt mit einer Parameterschwelle in Form einer Länge, zum Beispiel der Länge L der Gleichspannungsleitung verglichen werden. Zur Fehlererkennung kann dabei die Erfüllung der folgenden Bedingung herangezogen werden:

$$D \ < \ L.$$

Bevorzugt wird aus der Impedanz eine Reaktanz der Gleichspannungsleitung bestimmt. Der Kennparameter wird anschließend aus der Reaktanz abgeleitet. Nach eigenen Untersuchungen ist der resistive Anteil der Impedanz unter Umständen empfindlich gegenüber dem Übergangswiderstand an der Fehlerstelle und der Leitungstemperatur. Der reaktive Anteil der Impedanz ist hingegen hauptsächlich durch die Geometrie der Anordnung bedingt. Durch die Verwendung der Reaktanz anstelle der Impedanz kann das Verfahren vorteilhaft unempfindlicher gegenüber den genannten Störfaktoren gemacht werden. In diesem Fall kann der Kennparameter durch die Gleichung D = Xm/X'sp definiert werden, wobei Xm eine aus der Messung ermittelte Reaktanz der Gleichspannungsleitung und X'sp eine spezifische Reaktanz der Gleichspannungsleitung sind.

Wie bereits zuvor erwähnt, kann der zeitveränderliche Strom in einer Gleichspannungsleitung besonders wirksam erzeugt werden, in der in einem Normalbetrieb der regelbaren Einrichtung kein Strom oder ein vernachlässigbarer Strom fließt. Aus diesem Grund ist das Verfahren bei einer Gleichspannungsleitung besonders bevorzugt anwendbar, die eine DMR-Leitung einer Gleichstromübertragungsanordnung ist.

Es kann von Vorteil sein, wenn der Kennparameter anhand einer kalibrierten Kennlinie abgeleitet wird. Mittels der Kennlinie, insbesondere einer nichtlinearen Kennlinie, können nichtlineare Abhängigkeiten der Impedanz berücksichtigt werden, wie beispielsweise nichtlineare Eigenschaften von Leitungsparametern oder die Kapazität der Gleichspannungsleitung.

Das Verfahren kann vorteilhaft dazu genutzt werden, anhand des Kennparameters einen Fehlerort zu ermitteln. Wird demnach ein Fehler in der Gleichspannungsleitung festgestellt, so wird mit Hilfe des Kennparameters auch der jeweilige Ort des Fehlers bestimmt. Ist der Kennparameters als Entfernung gegeben, so kann die Entfernung direkt als Fehlerort genutzt werden. Dabei kann zusätzlich beispielsweise überprüft werden, ob die Entfernung D kleiner als die Länge der Gleichspannungsleitung ist. Auf diese Weise kann vorteilhaft die Fehlerbehebung erleichtert werden.

Die Erfindung betrifft ferner eine Anordnung mit einer regelbaren Einrichtung, die zur Erzeugung eines Stromes in einer Gleichspannungsleitung eingerichtet ist, sowie mit einer Regelungseinrichtung zum Regeln der regelbaren Einrichtung.

Eine solche Anordnung ist beispielsweise als Hochspannungsgleichstromübertragungsanordnung (HGÜ-Anordnung) bekannt. Die regelbare Einrichtung ist in diesem Fall ein regelbarer Umrichter, der gleichspannungsseitig mit der Gleichspannungsleitung und wechselspanungsseitig mit einem Wechselspannungsnetz verbunden ist. Der Umrichter umfasst üblicherweise steuerbare Halbleiterschalter wie beispielsweise Thyristoren oder IGBT-Schalter. Mittels einer geeigneten Ansteuerung der Halbleiterschalter, die beispielsweise mittels der Regelungseinrichtung durchgeführt werden kann, kann mittels des Umrichters ein Strom in der Gleichspannungsleitung erzeugt werden.

Die Aufgabe der Erfindung besteht darin, eine artgemäße Anordnung anzugeben, die möglichst zuverlässig ist.

Die Aufgabe wird erfindungsgemäß dadurch gelöst, dass die Regelungseinrichtung zum Durchführen des erfindungsgemäßen Verfahrens eingerichtet ist.

Die Vorteile der erfindungsgemäßen Anordnung ergeben sich insbesondere aus den Vorteilen, die zuvor im Zusammenhang mit dem erfindungsgemäßen Verfahren beschrieben wurden.

Vorzugsweise ist die Anordnung eine Gleichstromübertragungsanordnung, wobei die regelbare Einrichtung ein Umrichter ist, der gleichspannungsseitig mit der Gleichspannungsleitung verbindbar ist. Die Gleichstromübertragungsanordnung kann zum Beispiel eine MVDC- oder HVDC-Anlage sein. Die Gleichstromübertragungsanordnung kann beispielsweise in einer Monopol-Anordnung oder einer Bipol-Anordnung angeordnet sein. Die Gleichspannungsleitung ist bevorzugt eine DMR-Leitung.

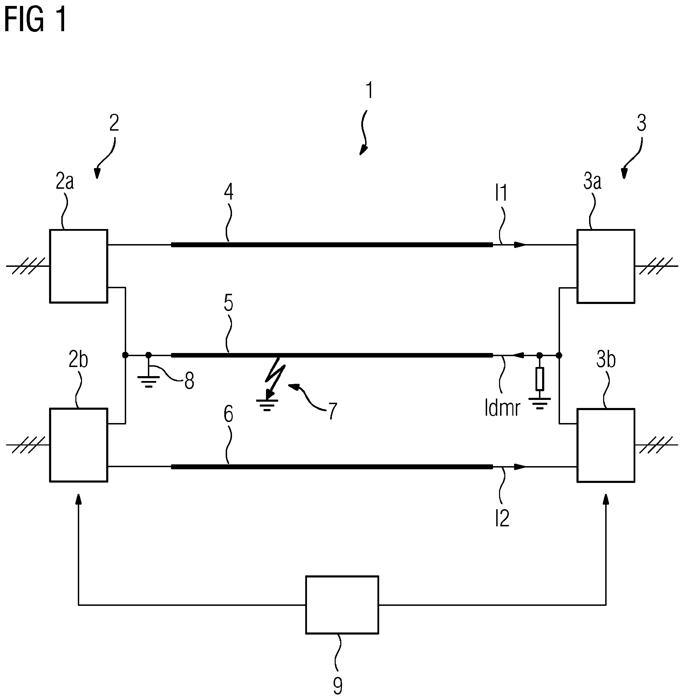

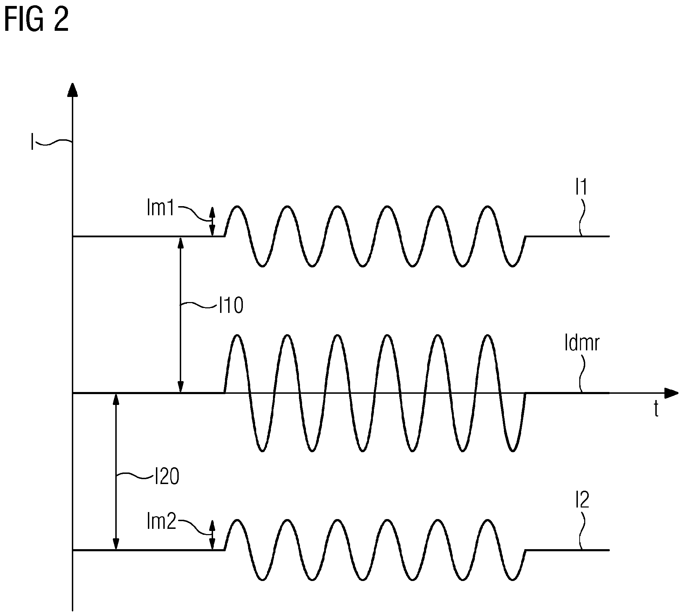

Die Erfindung soll im Folgenden anhand eines in den Figuren 1 und 2 dargestellten Ausführungsbeispiels weiter erläutert werden.

Figur 1 zeigt eine erfindungsgemäße Anordnung in einer schematischen Darstellung;

Figur 2 zeigt schematisch die Erzeugung eines zeitveränderlichen Stromes in einer Ausführungsform des erfindungsgemäßen Verfahrens.

In Figur 1 ist eine Gleichstromübertragungsanordnung 1 in einer Bipol-Konfiguration dargestellt. Die Gleichstromübertragungsanordnung 1 umfasst eine erste Umrichterstation 2 und eine zweite Umrichterstation 3. Die erste Umrichterstation 2 weist einen ersten Umrichter 2a und einen zweiten Umrichter 2b, die in einer Reihenschaltung angeordnet sind. Entsprechend weist die zweite Umrichterstation 3 einen dritten Umrichter 3a und einen vierten Umrichter 3b in einer weiteren Reihenschaltung. Der erste Umrichter 2a und der dritte Umrichter 3a sind miteinander mittels einer ersten Gleichspannungsleitung 4 und einer zweiten Gleichspannungsleitung 5 verbunden. Der zweite Umrichter 2b und der vierte Umrichter 3b sind mittels der zweiten Gleichspannungsleitung 5 und einer dritten Gleichspannungsleitung 6 miteinander verbunden. Die erste Gleichspannungsleitung 4 liegt in einem Normalbetrieb der Anordnung 1 auf einem positiven Hochspannungs- oder Mittelspannungspotenzial und führt einen ersten Strom I1. Die dritte Gleichspannungsleitung 6 liegt im Normalbetrieb auf einem negativen Potenzial und führt einen zweiten Strom I2. Die zweite Gleichspannungsleitung 5 ist eine DMR-Leitung. Die erste Umrichterstation 2 ist geerdet, was in Figur 1 mit einem Erdungszeichen 8 angedeutet ist.

In einem symmetrischen bipolaren Betrieb der Anordnung 1 werden die Umrichterstationen 2, 3 derart geregelt, dass im Wesentlichen der Strom in der DMR-Leitung 5 sehr klein ist.

In dem in Figur 1 dargestellten Beispiel liegt ein Fehler in der zweiten Gleichspannungsleitung 5 vor. Der Fehler bzw. der Fehlerort ist mit einem gezackten Pfeil 7 angedeutet. Bei dem Fehler handelt es sich im dargestellten Beispiel um einen Erdfehler. Eine Regelungseinrichtung 9 ist dazu eingerichtet, eine Regelung der ersten und/oder der zweiten Umrichterstation 3 bzw. deren Umrichter 2a,b, 3a,b durchzuführen.

Das Verfahren zum Detektieren beziehungsweise Lokalisieren des Fehlers in der zweiten Gleichspannungsleitung 5 wird im Folgenden schrittweise beschrieben. In einem ersten Verfahrensschritt wird die nicht direkt geerdete, zweite Umrichterstation 3 mittels der Regelungseinrichtung 9 derart geregelt, dass ein erster Stromsollwert für den dritten Umrichter 3a und ein zweiter Stromsollwert für den vierten Umrichter 3b verändert werden. Es ist hierbei genauso möglich, diese Regelung an der ersten Umrichterstation 2 durchzuführen. Die Stromsollwerte werden dabei derart eingestellt, dass Sinusstrom durch die zweite Gleichspannungsleitung 5 erzeugt wird. Insbesondere wird auf die beiden Ströme I1 und I2 ein Wechselstromanteil gemäß der folgenden Beziehung aufmoduliert:

$$I1 = I10 + Im1 * cos(2*Pi*fm*t + Phim1),$$

$$I2 = I20 + Im2 * cos(2*Pi*fm*t + Phim2).$$

Dabei bezeichnet I10 den Gleichstromanteil des Stromes I1, Pi die Kreiszahl, fm die Frequenz des Wechselstromanteils und Phim1,2 die Phasenverschiebungen. Werden beispielsweise folgende Beziehungen für die Parameter gewählt: Phim1=Phim2, I10=-I20 und Im1=Im2, so ergibt sich für den resultierenden Strom Idmr durch die zweite Gleichspannungsleitung 5:

$$\mathtt{Idmr\ =\ I1\ +\ I2\ =\ 2\ *\ Im1\ *\ cos(2*Pi*fm*t\ +\ Phim1).}$$

Es ergibt sich also ein Sinusstrom Idmr durch die zweite Gleichspannungsleitung 5.

In einem zweiten Verfahrensschritt werden mittels geeigneter Messvorrichtungen (in Figur 1 figürlich nicht dargestellt) eine Spannung Udmr und der Strom Idmr durch die Gleichspannungsleitung gemessen. Aus den gemessenen Größen kann eine Impedanz Zdmr der Gleichspannungsleitung gemäß der Formel Zdmr = Udmr/Idmr berechnet werden. Die Impedanz Zdmr ist eine komplexe Größe, deren Imaginärteil die Reaktanz Xdmr ist. Mittels einer FFT kann die Reaktanz Xdmr bestimmt werden. Hierbei wird die FFT insbesondere zur Bestimmung von Amplitude und Phase des Stromes bzw. der Spannung eingesetzt. Daraus kann geeigneterweise der reaktive und der resistive Anteil der Fehlerimpedanz abgeleitet werden.

Im nächsten Verfahrensschritt wird ein Kennparameter D gemäß der Beziehung D = Xdmr/X'dmr bestimmt, wobei X'dmr eine spezifische Reaktanz der DMR-Leitung 5 in ohm/km ist.

In einem darauffolgenden Verfahrensschritt wird überprüft, ob der Kennparameter D oberhalb oder unterhalb einer vorbestimmten Parameterschwelle L liegt, die in diesem Beispiel als die Länge der zweiten Gleichspannungsleitung 5 definiert ist.

Eine Fehlermeldung wird schließlich generiert, falls der Kennparameter unterhalb der Parameterschwelle liegt.

In Figur 2 ist ein Diagramm gezeigt, in dem waagerecht eine Zeitachse t und senkrecht eine Stromamplitudenachse I dargestellt sind. In dem Diagramm der Figur 2 ist der Zeitverlauf einiger der Ströme in der Anordnung 1 der Figur 1 dargestellt, nämlich:

- der Strom I1 durch die erste Gleichspannungsleitung 4 als eine Überlagerung des positiven Gleichstroms I10 und eines Wechselstromanteils,
- der Strom I2 durch die dritte Gleichspannungsleitung 6 als eine Überlagerung des negativen Gleichstroms I20 und eines Wechselstromanteils,
- der Strom Idmr in der zweiten Gleichspannungsleitung 5 als eine Überlagerung der beiden Ströme I1 und I2.

Im1 und Im2 bezeichnen die Amplituden der Wechselstromanteile der Ströme I1 bzw. I2.

**Patentansprüche**

1. Verfahren zum Detektieren eines Fehlers in einer Gleichspannungsleitung (5), die mit wenigstens einer regelbaren Einrichtung (2,3) zum Erzeugen eines Stromes in der Gleichspannungsleitung (5) verbunden ist, bei dem

    - wenigstens ein Sollwert einer Regelungseinrichtung (9) zum Regeln der regelbaren Einrichtung (2,3) für eine vorbestimmte Zeit derart eingestellt wird, dass ein zeitveränderlicher Strom durch die Gleichspannungsleitung (5) erzeugt wird,
    - eine Spannung und der Strom durch die Gleichspannungsleitung (5) gemessen werden,
    - eine Impedanz der Gleichspannungsleitung (5) aus der gemessenen Spannung und dem gemessenen Strom bestimmt wird,
    - aus der Impedanz ein Kennparameter abgeleitet wird, wobei der Kennparameter eine Entfernung ist und aus dem Verhältnis der gemessenen Impedanz und einer spezifischen Impedanz der Gleichspannungsleitung bestimmt wird,
    - überprüft wird, ob der Kennparameter unterhalb einer vorbestimmten Parameterschwelle liegt,
    - falls der Kennparameter unterhalb der Parameterschwelle liegt, eine Fehlermeldung erzeugt wird.

2. Verfahren nach Anspruch 1, wobei der zeitveränderliche Strom ein periodischer Strom, insbesondere ein Sinusstrom ist.

3. Verfahren nach einem der vorangehenden Ansprüche, wobei die Impedanz mittels einer FFT bestimmt wird.

4. Verfahren nach einem der vorangehenden Ansprüche, wobei aus der Impedanz eine Reaktanz der Gleichspannungsleitung (5) bestimmt und der Kennparameter aus der Reaktanz abgeleitet wird.

5. Verfahren nach einem der vorangehenden Ansprüche, wobei die Gleichspannungsleitung (5) eine DMR-Leitung der Gleichstromübertragungsanordnung (1) ist.

6. Verfahren nach einem der vorangehenden Ansprüche, wobei der Kennparameter anhand einer kalibrierten Kennlinie abgeleitet wird.

7. Verfahren nach einem der vorangehenden Ansprüche, wobei anhand des Kennparameters ein Fehlerort ermittelt wird.

8. Anordnung (1) mit einer regelbaren Einrichtung (3), eingerichtet zum Erzeugen eines Stromes in einer Gleichspannungsleitung (5), sowie mit einer Regelungseinrichtung (9) zum Regeln der regelbaren Einrichtung (3), **dadurch gekennzeichnet, dass** die Regelungseinrichtung zum Durchführen des Verfahrens nach einem der Ansprüche 1 bis 7 eingerichtet ist.

9. Anordnung (1) nach Anspruch 8, wobei die Anordnung (1) eine Gleichstromübertragungsanordnung ist und die regelbare Einrichtung (3) ein Umrichter ist, der gleichspannungsseitig mit der Gleichspannungsleitung (5) verbindbar ist.

10. Anordnung nach Anspruch 9, wobei die Gleichspannungsleitung (5) eine DMR-Leitung ist.

**Claims**

1. Method for detecting a fault in a DC voltage line (5) that is connected to at least one controllable device (2, 3) for generating a current in the DC voltage line (5), in which

   - at least one target value of a control device (9) for controlling the controllable device (2, 3) is set for a predetermined time in such a way that a time-variable current is generated through the DC voltage line (5),
   - a voltage and the current through the DC voltage line (5) are measured,
   - an impedance of the DC voltage line (5) is determined from the measured voltage and the measured current,
   - a characteristic parameter is derived from the impedance, wherein the characteristic parameter is a distance and is determined from the ratio of the measured impedance and a specific impedance of the DC voltage line,
   - a check is carried out as to whether the characteristic parameter is below a predetermined parameter threshold,
   - if the characteristic parameter is below the parameter threshold, a fault message is generated.

2. Method according to Claim 1, wherein the time-variable current is a periodic current, in particular a sinusoidal current.

3. Method according to either of the preceding claims, wherein the impedance is determined by means of an FFT.

4. Method according to one of the preceding claims, wherein a reactance of the DC voltage line (5) is determined from the impedance and the characteristic parameter is derived from the reactance.

5. Method according to one of the preceding claims, wherein the DC voltage line (5) is a DMR line of the DC transmission arrangement (1).

6. Method according to one of the preceding claims, wherein the characteristic parameter is derived on the basis of a calibrated characteristic curve.

7. Method according to one of the preceding claims, wherein a fault location is ascertained on the basis of the characteristic parameter.

8. Arrangement (1) having a controllable device (3), configured to generate a current in a DC voltage line (5), and having a control device (9) for controlling the controllable device (3), **characterized in that** the control device is configured to carry out the method according to one of Claims 1 to 7.

9. Arrangement (1) according to Claim 8, wherein the arrangement (1) is a DC transmission arrangement and the controllable device (3) is a converter that can be connected on the DC voltage side to the DC voltage line (5).

**10.** Arrangement according to Claim 9, wherein the DC voltage line (5) is a DMR line.

**Revendications**

**1.** Procédé de détection d'un défaut dans une ligne (5) de tension continue, qui est reliée à au moins un dispositif (2,3) réglable pour la production d'un courant dans la ligne (5) de tension continue, dans lequel

- on établit pendant une durée déterminée à l'avance au moins une valeur de consigne d'un dispositif (9) de réglage pour régler le dispositif (2, 3) de réglage de manière à produire un courant variable dans le temps dans la ligne (5) de tension continue,
- on mesure une tension et le courant dans la ligne (5) de tension continue,
- on détermine une impédance de la ligne (5) de tension continue à partir de la tension mesurée et du courant mesuré,
- on déduit de l'impédance un paramètre caractéristique, le paramètre caractéristique étant une distance et on détermine le rapport de l'impédance mesurée et d'une impédance spécifique de la ligne de tension continue,
- on contrôle si le paramètre caractéristique est en dessous d'un seuil de paramètre déterminé à l'avance, si le paramètre caractéristique est en dessous du seuil de paramètre, on produit un message de défaut.

**2.** Procédé suivant la revendication 1, dans lequel le courant variable dans le temps est un courant périodique, notamment un courant sinusoïdal.

**3.** Procédé suivant l'une des revendications précédentes, dans lequel on détermine l'impédance au moyen d'une transformée de Fourier rapide.

**4.** Procédé suivant l'une des revendications précédentes, dans lequel on détermine à partir de l'impédance une réactance de la ligne de tension continue et on déduit le paramètre caractéristique de la réactance.

**5.** Procédé suivant l'une des revendications précédentes, dans lequel la ligne (5) de tension continue est une ligne DMR de l'agencement (1) de transport de courant continu.

**6.** Procédé suivant l'une des revendications précédentes, dans lequel on déduit le paramètre caractéristique à l'aide d'une courbe caractéristique étalonnée.

**7.** Procédé suivant l'une des revendications précédentes, dans lequel on détermine un emplacement du défaut à l'aide du paramètre caractéristique.

**8.** Agencement (1) comprenant un dispositif (3) réglable conçu pour produire un courant dans une ligne (5) de tension continue, ainsi qu'un dispositif (9) de réglage pour régler le dispositif (3) réglable, **caractérisé en ce que** le dispositif de réglage est conçu pour effectuer le procédé suivant l'une des revendications 1 à 7.

**9.** Agencement (1) suivant la revendication 8, dans lequel l'agencement (1) est un agencement de transport de courant continu et le dispositif (3) réglable est un convertisseur, qui peut être relié du côté de la tension continue à la ligne (5) de tension continue.

**10.** Agencement suivant la revendication 9, dans lequel la ligne (5) de tension continue est une ligne DMR.

FIG 1

FIG 2

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- CN 103837799 B

**In der Beschreibung aufgeführte Nicht-Patentliteratur**

- **V. PATHIRANA.** *Protection Strategy for HVDC Systems with Dedicated Metallic Return (DMR) Conductors*
- **LI et al.** Fault-location method for HVDC transmission lines based on phase frequency characteristics. *IET,* 2018
- **DAISY et al.** A new fault-location method for HVDC transmission-line based on DC components of voltage and current under linke parameter uncertainty. *Electr. Eng.,* 2017